(19) **Europäisches Patentamt**

**European Patent Office**

**Office européen des brevets**

(11) **EP 1 394 950 B1**

(12) **EUROPÄISCHE PATENTSCHRIFT**

(45) Veröffentlichungstag und Bekanntmachung des Hinweises auf die Patenterteilung:
**02.08.2006 Patentblatt 2006/31**

(51) Int Cl.:
***H03M 3/00*** *(2006.01)*

(21) Anmeldenummer: **02028135.8**

(22) Anmeldetag: **18.12.2002**

(54) **Quantisierer für einen Sigma-Delta-Modulator und Sigma-Delta-Modulator**

Quantiser for a sigma-delta modulator and sigma-delta modulator

Quantificateur pour un modulateur sigma-delta et modulateur sigma-delta

(84) Benannte Vertragsstaaten:
**DE FR GB**

(30) Priorität: **29.08.2002 DE 10239865**
**22.11.2002 DE 10254651**

(43) Veröffentlichungstag der Anmeldung:
**03.03.2004 Patentblatt 2004/10**

(73) Patentinhaber: **Infineon Technologies AG**
**81669 München (DE)**

(72) Erfinder:
• **Di Giandomenico, Antonio**
**9500 Villach (AT)**
• **Dörrer, Lukas**
**9500 Villach (AT)**
• **Wiesbauer, Andreas**
**9210 Pörtschach (AT)**

(74) Vertreter: **Reinhard - Skuhra - Weise & Partner**
**Friedrichstrasse 31**
**80801 München (DE)**

(56) Entgegenhaltungen:
| | |
|---|---|
| WO-A-01/93430 | WO-A-02/09292 |
| US-A- 4 251 803 | US-A- 5 550 544 |
| US-A- 5 805 093 | US-A- 5 896 101 |
| US-A- 5 907 299 | US-A- 5 990 814 |
| US-B1- 6 331 833 | US-B1- 6 426 714 |

• **RAMESH M C ET AL: "Sigma delta analog to digital converters with adaptive quantization" CIRCUITS AND SYSTEMS, 1997. PROCEEDINGS OF THE 40TH MIDWEST SYMPOSIUM ON SACRAMENTO, CA, USA 3-6 AUG. 1997, NEW YORK, NY, USA,IEEE, US, 3. August 1997 (1997-08-03), Seiten 22-25, XP010272481 ISBN: 0-7803-3694-1**
• **HERNÀNDEZ L: "Continuous-time sigma-delta modulators with reduced timing jitter sensitivity based on time delays" ELECTRONICS LETTERS, IEE STEVENAGE, GB, Bd. 39, Nr. 14, 10. Juli 2003 (2003-07-10), Seiten 1039-1041, XP006020629 ISSN: 0013-5194**
• **GAO W ET AL: "Excess loop delay effects in continuous-time delta-sigma modulators and the compensation solution" CIRCUITS AND SYSTEMS, 1997. ISCAS '97., PROCEEDINGS OF 1997 IEEE INTERNATIONAL SYMPOSIUM ON HONG KONG 9-12 JUNE 1997, NEW YORK, NY, USA,IEEE, US, 9. Juni 1997 (1997-06-09), Seiten 65-68, XP010235976 ISBN: 0-7803-3583-X**
• **OLIAEI O ET AL: "Jitter effects in continuous-time /spl Sigma//spl Delta/ modulators with delayed return-to-zero feedback" ELECTRONICS, CIRCUITS AND SYSTEMS, 1998 IEEE INTERNATIONAL CONFERENCE ON LISBOA, PORTUGAL 7-10 SEPT. 1998, PISCATAWAY, NJ, USA,IEEE, US, 7. September 1998 (1998-09-07), Seiten 351-354, XP010366123 ISBN: 0-7803-5008-1**

**Beschreibung**

Die Erfindung betrifft nach dem Oberbegriff des Patentanspruchs 1 einen Quantisierer für einen Sigma-Delta-Modulator mit mindestens einer Vorstufe, wobei der Quantisierer ein an ihm anliegendes Eingangssignal quantisiert und als Ergebniswert an einem digitalen Ergebnisausgang ausgibt. Die Erfindung betrifft weiterhin gemäß den Patentanspruch 6, d.h. einen Sigma-Delta-Modulator mit einem erfindungsgemäßen Quantisierer.

Die Sigma-Delta Modulation hat in den letzten Jahren zunehmende Bedeutung im Bereich der Analog/Digital (A/D)- und Digital/Analog (D/A)-Umwandlung gewonnen. Dies ist vor allen Dingen auf die geringen Ansprüche an die analogen Komponenten von Signal-Umsetzern zurückzuführen. Digitale Schaltungen gewinnen heutzutage in der Signalverarbeitung immer mehr an Bedeutung. Um Signale aus der analogen Umwelt zu konvertieren und anschließend digital verarbeiten zu können, sind A/D Wandler nötig. Es ist erstrebenswert, Wandler und die übrige digitale Schaltung auf einem einzigen Chip zu integrieren. Da meist der digitale Anteil die Chipfläche dominiert, bestimmt dieser auch die Schaltungstechnologie. Digitale Prozesstechnologien erschweren jedoch die Herstellung von präzisen analogen integrierten Schaltungskomponenten, bei denen sehr hohe Genauigkeiten und geringe Fertigungsschwankungen gefordert sind. Hier kommt die Einfachheit und Robustheit analoger Komponenten der Sigma-Delta-Modulatoren zum Tragen, die Sigma-Delta-Umsetzer für Implementierungen in beispielsweise einer digitalen VLSI-Technologie prädestinieren.

Ein weiterer Vorteil der Sigma-Delta-Modulatoren liegt darin, dass diese weniger Strom als herkömmliche A/D-Wandler benötigen, was sie auch in dem wichtigen Bereich der tragbaren Empfänger qualifiziert. Ebenso zeichnen sie sich durch eine höhere Signal Bandbreite aus, was sie interessant für den Anwendungsbereich in der xDSL-Transceiver-Technik macht.

Es sind Einzelbit-Delta-Sigma-Wandler bekannt, bei denen ein Differenzverstärker ein jeweiliges analoges Eingangssignal mit einem Rückkopplungssignal addiert. Das Ausgangssignal wird einem Integrierer zugeführt und von einem Komparator mit einem Referenzsignal verglichen. Die schnelle Abfolge von Vergleichsergebnissen ergibt das digitale Ausgangssignal des Einbit-Modulators, aus dem durch einen Digital-Analog-Wandler das Rückkopplungssignal gewonnen wird. Da bei dieser Delta-Sigma-Modulation der Ansteuerbereich des Differenzverstärkers nicht vollständig ausgenutzt wird, wurde in der US 5,907,299 eine Schaltung vorgeschlagen, bei der das Referenzsignal für den Komparator nachgeführt ist, und das zu wandelnde analoge Eingangssignal direkt dem Komparator zugeführt ist. Das Referenzsignal folgt bei der US 5,907,299 dabei dem Eingangssignal.

Um größere Eingangssignalpegel zuverlässig wandeln zu können, sind Multibit-Sigma-Delta-Wandler vorgeschlagen worden, die anstelle eines einfachen Komparators, Multibit-Quantisierer verwenden. Die US 6,331,833 B1 offenbart zum Beispiel einen Multibit-Analog-Digital-Wandler, bei dem in Abhängigkeit von dem Eingangssignalpegel Komparatoren zugeschaltet werden, um bessere Linearitätseigenschaften zu erreichen. Bei bestimmten Eingangssignalpegeln arbeiten die Komparatoren als Multi-Quantisierer in dem entsprechenden Multibit-Sigma-Delta-Modulator.

Problematisch bei Sigma-Delta-Modulatoren ist, gerade zu höheren zu wandelnden Frequenzen hin, dass Laufzeitverzögerungen in den einzelnen Komponenten (Excess Loop Delay) Fehler auftreten, was die Anwendung zu hohen Frequenzen (>1 GHz) hin beschränkt. Zu der Problematik der Excess Loop Delays siehe auch: J. A. Cherry, W. M. Snelgrove, Continuous-Time Detla-Sigma Modulator for High Speed A/D Conversion, Kluwer Academic Publishers 2000, Seite 75-103.

Ein bekannter Weg diese durch Laufzeitunterschiede induzierte Fehler auszugleichen, schlägt P. Benabes, M. Keramat, R. Kielbasa, A methodology for designing continuous-time sigma-delta modulators, IEEE European Design and Test Conference 1997, Seite 45-50 vor, einen zusätzlichen Rückkoppelkreis (inner loop) einzuführen, der durch einen zusätzlichen Addierer zwischen dem Quantisierer und dem letzten davor befindlichen Integrierer gebildet ist.

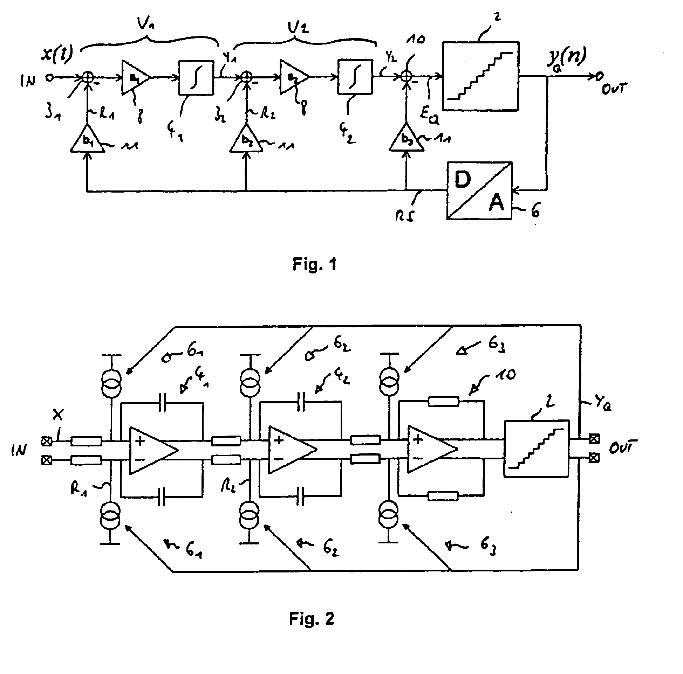

In Figur 1 ist ein gewöhnlicher zeitkontinuierlicher Sigma-Delta-Modulator zweiter Ordnung mit zwei Vorstufen $V_1$ und $V_2$ sowie mit Korrekturmitteln gezeigt. Das am Eingang IN anliegende zu wandelnde Signal x wird über zwei Integrierer $4_1$ und $4_2$, denen jeweils ein Addierer $3_1$ bzw. $3_2$ zur Verknüpfung mit dem Rückkoppelsignal vorgeschaltet ist, dem Quantisierer 2 an dessen Eingang zugeführt. Zuvor jedoch wird das zu quantisierende Signal $y_2$ jedoch noch über den Addierer 10 nochmals mit dem Rückkoppelsignal RS verknüpft. Hierdurch wird der Einfluss der Laufzeit in den einzelnen Komponenten berücksichtigt und ausgeglichen.

In Figur 2 ist eine aus W. Redman-White, A. M. Durham, A fourth order Converter with self-tuning Continuous Time Noise Shaper", aus Proceedings of ESSCIRC 1991, Seite 249-252 bekannte mögliche Umsetzung eines solchen Konzeptes gezeigt.

Hierbei kommen als Digital-Analog-Wandler für das Rückkopplungs-Signal $R_i$ Strom-AD-Wandler $6_1$, $6_2$ zum Einsatz, wobei die Integratoren $4_1$ und $4_2$ durch Operationsverstärker gebildet sind und auch der Kompensations-Addierer 10 durch einen Operationsverstärker mit vorgeschaltetem Strom-AD-Wandler $6_3$ ausgebildet ist. Bei dieser Lösung sind die Summierknoten $3_i$ durch die Eingänge der Operationsverstärker gebildet. Die Summiersignale sind die Ströme, die durch die Eingangswiderstände und in den Stromgeneratoren im jeweiligen Rückkoppelkreis fließen.

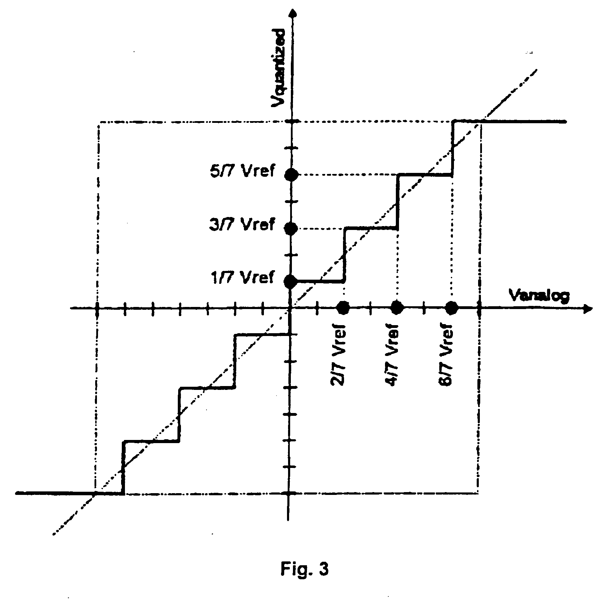

Figur 3 zeigt ein Diagramm eines so aufgebauten 3 Bit auflösenden Sigma-Delta-Modulators, bei dem 7 Schwellspannungen angewendet werden.

Gemäß der oben angegebenen Anordnung wird die Summe mit dem Rückkoppel-Signal vor dem Quantisierer gebildet. Die Komparatoren i = 1 bis N des Quantisierers müssen daher die Bewertung

$$(V_2 - V_{dac3}) > V_{th,i}$$

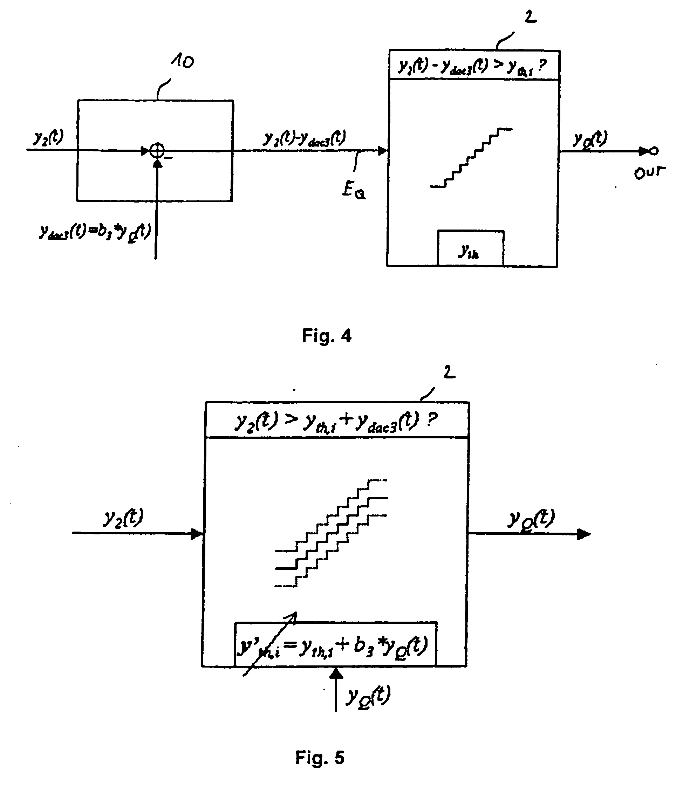

durchführen, wobei $V_{dac3} = b_3 * y_Q(t)$ (siehe hierzu Figur 4). $V_2$ ist hierbei der Betrag des Zwischensignals $y_2$ nach dem zweiten Integrierer $4_2$.

Nachteilig bei dieser Anordnung und Vorgehensweise ist jedoch, dass im Signalweg ein hochgenaues aktives Element (zusätzlicher Addierer) vorzusehen ist, mit all den Schwierigkeiten bezüglich Herstellungsverfahren und - schritten, Layoutdesign und Ausschuss bei der Herstellung und, dass der Stromverbrauch hierdurch erheblich erhöht wird, was die Anwendungsbereiche gerade bei tragbaren und zwingend stromsparenden Anwendungen beschränkt.

Aufgabe der Erfindung ist es daher, einen Sigma-Delta-Modulator und einen Quantisierer zur Verfügung zu stellen, bei dem eine Kompensation der Laufzeiten durch die einzelnen Komponenten erfolgt, wobei jedoch im Signalweg kein zusätzliches Element vorgesehen ist.

Diese Aufgabe wird durch die kennzeichnenden Merkmale des Anspruchs 1 gelöst.

Erfindungsgemäß ist vorgesehen, dass der Quantisierer entsprechend der Anzahl der Schwellwertsignale Komparatoren aufweist welche das Eingangssignal mit der jeweiligen Schwellwertsignal vergleichen, wobei die Schwellwertsignale um eine Korrektur-Spannung verringert oder erhöht ist, wobei die Korrektur-Spannung entsprechend dem am Ergebnisausgang ausgegebenen Ergebniswert generiert ist.

Die Erfindung schlägt vor, eine Anpassung der Schwellspannungen für die Komparatoren im Quantisierer vorzunehmen und nicht mehr wie bisher eine Anpassung des zu quantisierenden Signals im Signalweg vor dem Quantisierer vorzunehmen. Hierdurch wird das Design der Halbleiterschaltung erheblich einfacher und ist auch nicht mehr so kritisch in der Herstellung, da Toleranzen hier weiter sein dürfen als bei aktiven analogen Elementen direkt im Signalweg. Der zusätzliche Summierer ist eingespart. Eine Anpassung der Schwellspannung kann über einen ganzen Taktzyklus erfolgen, was ausreichend viel Zeit ist. Das ganze System ist stabiler und produziert auch nicht mehr so viele Laufzeitfehler, da ein aktives Element aus dem Signalweg entfernt worden ist. Dies verringert zudem den Stromverbrauch des Sigma-Delta-Modulators und er ist mit weniger Platzverbrauch auf einem Chip realisierbar. Zudem sind höhere Abtastraten realisierbar, da durch die Verringerung der Laufzeitfehler die Abtastrate erhöht ist. Anwendungen im xDSL-Bereich mit den hohen Abtastraten sind leichter realisierbar, der Einsatzbereich der Sigma-Delta-Modulatoren ist vergrößert als bisher denkbar.

Eine bevorzugte Ausgestaltung der Erfindung sieht vor, dass ein Digital-Analog-Wandler vorgesehen ist, der ein analoges Roh-Signal aus dem digitalen Ergebniswert generiert. Hierdurch kann in einfacher Weise ein Rückkoppel-Signal mit einem Faktor belegt den einzelnen Addierern zugeführt werden.

Bevorzugterweise wird das Roh-Signal entsprechend der Position und der Anzahl der Vorstufen im Signalweg jeweils mit einem vorbestimmten Faktor zum jeweiligen Rückkopplungs-Signal einer Vorstufe multipliziert.

Von Vorteil ist die Korrektur-Spannung eine dem mit einem festen Faktor multiplizierten Ergebniswert entsprechende Spannung.

Eine Ausgestaltung der Erfindung sieht vor, dass der Faktor eine einfach gebrochene Zahl ist.

Eine bevorzugte Ausgestaltung der Erfindung sieht vor, dass ein digitaler Addierer vorgesehen ist, der zum Ergebniswert den Faktor addiert und eine dem Ergebnis entsprechende vorher generierte Schwellspannung auf die Komparatoren aufschaltet.

Von Vorteil ist ein Digital-Analog-Wandler vorgesehen, der die dem Ergebniswert entsprechende Spannung erzeugt.

Gemäß einer besonders bevorzugten Ausgestaltung der Erfindung ist vorgesehen, dass der Sigma-Delta-Modulator von zweiter Ordnung mit zwei Vorstufen ist.

Von Vorteil, und daher bevorzugterweise ist der Sigma-Delta-Modulator ein zeitkontinuierlicher Sigma-Delta-Modulator (continuous time sigma delta modulator).

Vorteilhafterweise ist eine der Auflösung des Quantisierers entsprechende Anzahl von Komparatoren vorgesehen, wobei die Komparatoren gleichmäßig gestaffelte Schwellspannungen aufweisen.

Dem folgend, ist nach einer Ausgestaltung der Erfindung vorgesehen, dass ein Referenzspannungsgenerator vorgesehen ist, welcher Teil-Spannungen liefert aus welchen die Schwellspannungen generiert werden.

Weitere Vorteile, Besonderheiten und zweckmäßige Weiterbildungen der Erfindung ergeben sich aus den weiteren Unteransprüchen oder deren Unterkombinationen.

Nachfolgend wird die Erfindung anhand der Zeichnung weiter erläutert.

Dabei zeigt:

Fig. 1    einen zeitkontinuierlichen Sigma-Delta-Modulator nach dem Stand der Technik,

Fig. 2    eine konkrete Ausführung des zeitkontinuierlichen Sigma-Delta-Modulators aus Figur 1,

Fig. 3    ein schematisches Diagramm der Quantisierungsschritte über der analogen Eingangsspannung,

Fig. 4    einen Ausschnitt aus Figur 1, wobei die Signale verdeutlicht sind,

Fig. 5    einen erfindungsgemäßen Quantisierer schematisch mit den einzelnen Signalen, entsprechend dem Ausschnitt aus Figur 4,

Fig. 6    einen erfindungsgemäßen zeitkontinuierlichen Sigma-Delta-Modulator, und

Fig. 7    eine schematische Darstellung eines konkreteren Aufbaus eines erfindungsgemäßen Quantisierers.

In den Figuren bezeichnen gleiche Bezugszeichen gleiche oder gleich wirkende Elemente.

Die Figur 5 zeigt deutlich den Unterschied zu bisher bekannten Ansätzen (siehe hierzu Figur 4). Die Komparatoren i = 1 bis N des Quantisierers haben nicht mehr die Bewertung

$$(V_{Eingang} - V_{dac3}) > V_{th,i}$$

durchzuführen, sondern

$$V_{Eingang} > V_{th,i} + V_{dac3}.$$

Demnach muss auch keine Signalverschiebung mehr im Signalweg vor den Komparatoren erfolgen. Bei jedem Taktzyklus wird jedem Komparator des Quantisierers eine angepasste Schwellwertspannung zugeführt: $y'_{th,i} = y_{th,i} + Y_{dac3}(t)$. Die durchgezogen gezeichnete Rampenspannung soll die angepasste Spannung verdeutlichen. Bei einem 3 Bit Quantisierer müssten eigentlich acht verschobene Rampen gezeichnet werden, diese wurden jedoch zur Erhaltung der Übersichtlichkeit weggelassen.

Das neue Prinzip ist die Summation des Rückkoppelsignals zu den Schwellspannungen der Komparatoren.

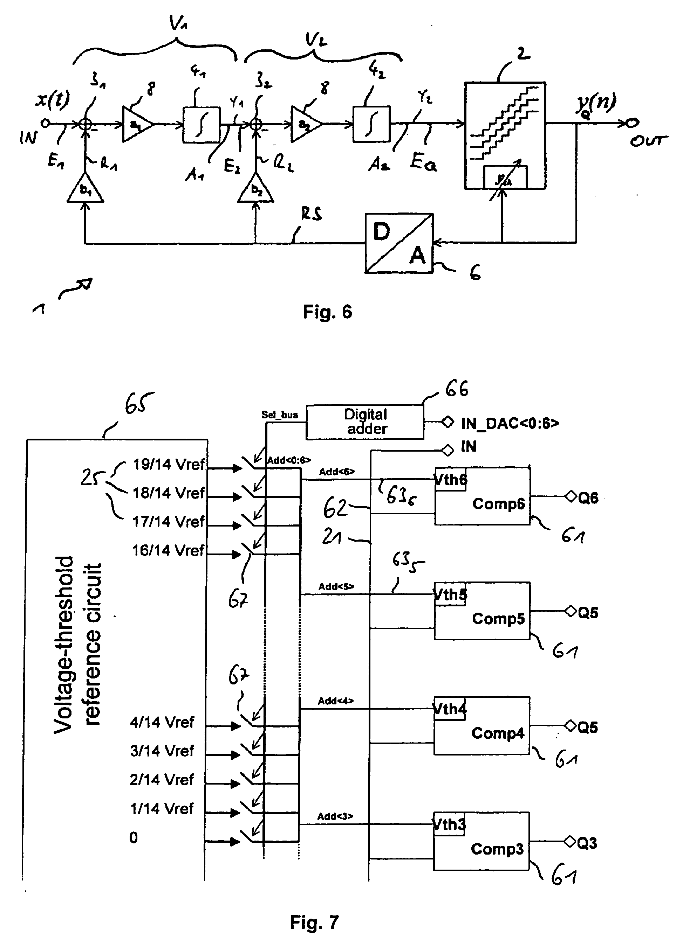

Eine unkritische Anpassung der Schwellspannungen der Komparatoren im Quantisierer ist ausreichend. Die Wandlung des digitalen Ergebnisses $y_Q$ in eine eigene analoge Spannung ist nicht notwendig. Eine digitale Addition der Werte mit nachfolgender entsprechender Aufschaltung einer Referenzspannung ist einfach möglich (siehe hierzu auch Figur 7).

Figur 6 zeigt den erfindungsgemäßen Ansatz.

Konkret ist die Summation der Schwellspannungen $y_{th,i}$ zu der Korrektur-Spannung $y_{dac3}$ (= $b_3 * Y_Q$) sehr einfach möglich, da der Faktor $b_3$ zumeist ein einfacher gebrochener Wert (beispielsweise 1/2, 3/4, ...) ist.

Hierdurch kann die Schwellspannung $y_{th,i}$ schnell und dynamisch erfolgen, ohne in die bekannten und bewährten Strukturen der die Schwellspannungen liefernden Schaltungen eingreifen zu müssen. Dies gilt für den digitalen als auch für den analogen Bereich, auch mit Strom- oder Spannungsreferenz.

Der erfindungsgemäße Ansatz hat keine festen Schwellspannungen $y_{th,i}$ mehr, sondern passt diese jeweils um die aktuelle Korrektur-Spannung $y_{dac3}$ = $b_3 *$ $y_Q$ an.

In Figur 7 ist schematisch eine Realisierung eines Quantisierers für einen Sigma-Delta-Modulator mit $b_3$ = 1/2 und acht Schwellen gezeigt, bei dem die Addition des Rückkoppelwertes IN_DAC<0:6> schon in der rein digitalen Domäne vorgenommen wird. Ein Digital-Analog-Wandler wird hierzu nicht benötigt. Die Teil-Referenzspannungen x * Vref werden beispielsweise durch eine Widerstandskette erzeugt.

Ein digitaler Addierer 66 ist vorgesehen, welcher den digitalen Ergebniswert IN_DAC<0:6> der letzen Bewertung der Komparatoren 61 des Quantisierers auf die Schwellwertsignal-Spannungen aufaddiert, indem er die Schwellwertsignal-Spannungen $63_i$ um dem digitalen Ergebniswert entsprechende Stufen erhöht oder verringert. Hierzu werden Schalter 67 entsprechend geöffnet oder geschlossen.

Die Anpassung an die Laufzeitunterschiede durch den Faktor b3 kann hierbei in dem Addierer 66 selbst erfolgen, welcher entsprechend dem Additionsergebnis mit dem Rückkoppelwert IN_DAC<0:6> (Ergebnis der vorherigen Bewertung des Quantisierers) die entsprechenden Schwellwertspannungen $V_{th,i}$ mittels der Schalter 67 auf die einzelnen Eingänge der Komparatoren 61 aufschaltet, welche dann die Bewertung mit dem Eingangssignal 62 (IN) zum jeweiligen Ergebnisbit Qi vornehmen.

Der Quantisierer verfügt über mehrere Komparatoren 61 entsprechend der Anzahl seiner Auflösungsstufen.

Die Komparatoren 61 vergleichen die Eingangssignal-Spannung 62 (IN) mit jeweils ihrer Schwellwertsignal-Spannung $63_i$, und im Falle des Übersteigens oder Unterschreitens des Schwellwertsignals durch das Eingangssignal wird ein entsprechendes digitales Ergebnisbit (0/1) (Qi) ausgegeben.

Zur Generierung der verschiedenen Schwellwertsignal-Spannungen $63_i$ ist ein Referenzspannungsgenerator 65 vorgesehen, der jedem Spannungskomparator 61 über die Schalter 67 entsprechend den Ausgangsdaten Add<0:6> des Addierers 66 eine eigene Schwellwertsignal-Spannung $63_i$ zugeführt. Die Differenzen der einzelnen Schwellwertsignal-Spannungen $63_i$ bleibt dabei gleich, es wird jedoch entsprechend dem Ergebnis Add<0:6> des Addierers 66 das Spannungsniveau jeder Schwellwertsignal-Spannung $63_i$ entsprechend dem Ergebnis IN_DAC<0:6> der vorherigen Bewertung des Quantisierers erhöht oder gesenkt.

Entsprechend dem Ergebnis der Summation werden also Teil-Spannungen 1/14 * Vref, 2/14 * Vref, ... zur Schwellspannung $V_{th}$ durch Öffnen und Schließen von Schaltern aufsummiert und auf die Komparatoren 61 geschaltet. Im dargestellten Beispiel und im folgenden ist ein 3-Bit Quantisierer mit 7 Stufen gezeigt, bei dem b3 = 1/2 gewählt ist. Es sind jedoch auch andere Werte und Auflösungen je nach Anwendung realisierbar.

Die sieben Schwellspannungen der Komparatoren sind bezüglich Vref daher nicht mehr fest. Zu den vorher festen Grundspannungen (bezüglich Vref) +12/14, +8/14, +4/14, 0, -4/14, -8/14, -12/14 wird bei jedem Taktzyklus entsprechend dem tatsächlichen und augenblicklichen Wert vom Ergebniswert vom digitalen Addierer 66 einer der folgenden Werte zu allen Schwellwert-Spannungen hinzusummiert: +7/14, +5/14, +3/14, +1/14, -1/14, -3/14, -5/14, -7/14 die sich daraus ergebenden 7 Signale werden mit dem zu bewertenden aktuellen Eingangssignal des Quantisierers durch die Komparatoren vergleichen, wodurch das nächste digitale Ergebnis generiert wird.

Die Anordnung der Komparatoren und die Komparatoren selber können auch wieder symmetrisch mit einem positiven und einem negativen Signalweg ausgebildet sein.

Bezugszeichenliste

| 1 | Sigma-Delta-Modulator |
|---|---|
| 2 | Quantisierer |
| 3i | Addierer |
| 4i | Integrierer |
| $5_i$, 61 | Komparatoren |
| 6 | Digital-Analog-Wandler |
| 7,66 | digitaler Addierer |
| 8 | Verstärker |
| 9 | Referenzspannungsgenerator |
| 10 | Kompensations-Addierer |
| 11 | Multiplizierer |
| 62 | Eingangssignal |
| $63_i$ | Schwellwertssignal-Spannung |
| 67 | Schalter |
| IN | Signaleingang |
| OUT | Ergebnisausgang |
| x | Auswertesignal |
| $y_Q$ | Ergebniswert |
| $y_1$, $y_2$ | Zwischensignale |
| $E_Q$ | Eingangssignal |
| $y_{th,i}$, $63_i$ | Schwellwertspannung |
| $y_{dac3}$ | Korrektur-Spannung |
| $V_i$ | Vorstufe |
| $E_i$ | Vorstufen-Eingangssignal |
| $A_i$ | Vorstufen-Ausgangssignal |
| $R_i$ | Rückkopplungs-Signal |
| RS | Roh-Signal |
| $b_3$ | Faktor |
| Qi | Ergebnisbit |

**Patentansprüche**

1. Multibit-Quantisierer (2) für einen Sigma-Delta-Modulator (1), wobei:

   a) der Sigma-Delta-Modulator (1) mindestens eine Vorstufe ($V_1$, $V_2$) mit einem Integrierer ($4_1$, $4_2$) aufweist und die Vorstufe ein analoges Eingangssignal ($E_Q$) an den Multibit-Quantisierer (2) liefert,
   b) der Multibit-Quantisierer (2) das analoge Eingangssignal ($E_Q$) quantisiert und als einen digitalen Ergebniswert ($y_Q$) an einem digitalen Ergebnisausgang (OUT) ausgibt,
   c) der Multibit-Quantisierer (2) mehrere Komparatoren (61) aufweist, welchen jeweils das analoge Eingangssignal ($E_Q$) zugeführt ist;
   **dadurch gekennzeichnet**,
   d) dass jedem Komparator (61) ein variables Schwellwertsignal ($y_{th,i}$) mit einer jeweiligen Schwellwertsignal-Spannung ($63_j$) zugeführt ist und der Komparator (61) ein jeweiliges Ergebnisbit (Qi) ausgibt, wobei die Ergebnisbits (Qi) den digitalen Ergebniswert ($y_Q$) bilden;
   e) dass ein digitaler Addierer (66) vorgesehen ist, welcher die Schwellwertsignal-Spannungen ($63_i$) in Abhängigkeit von dem digitalen Ergebniswert ($y_Q$) um eine Korrektur-Spannung ($Y_{dac3}$) verringert oder erhöht, wobei die Korrekturspannung ($Y_{dac3}$) für alle Schwellwertsignal-Spannungen ($63_i$) gleich ist.

2. Multibit-Quantisierer (2) nach Anspruch 1, **dadurch gekennzeichnet**, **dass** die Anzahl der Komparatoren (61) der Auflösung des Quantisierers (2) entspricht, und die Schwellwertsignalspannungen ($V_{th,i}$) äquidistant sind.

3. Multibit-Quantisierer (2) nach Anspruch 2, **dadurch gekennzeichnet**, **dass** ein Referenzspannungsgenerator (65) vorgesehen ist, der die für jeden Komparator (61) unterschiedlichen Schwellwertsignal-Spannungen ($63_i$) erzeugt, wobei die Schwellwertssignal-Spannungen ($63_i$) in Teil-Spannungen (25) wählbar sind.

4. Multibit-Quantisierer (2) nach Anspruch 3, **dadurch gekennzeichnet**, **dass** dem digitalen Addierer (66) ein Schaltwerk (65, 67) zugeordnet ist, welches steuerbare Schaltwerk-Schalter (67) aufweist, welche die Teil-Spannungen (25) des Referenzspannungsgenerators (65) an Eingänge der Komparatoren (61) für die Schwellwertsignal-Spannungen ($63_i$) schalten, wobei die Schalter durch Ausgangssignale (Add<0:6>) des digitalen Addierers (66) gesteuert sind.

**5.** Multibit-Quantisierer (2) nach einem der Ansprüche 1 - 4,
**dadurch gekennzeichnet,**
**dass** die Korrekturspannung ($y_{dac3}$) dem mit einem festen Faktor ($b_3$) multiplizierten Ergebniswert ($y_Q$) entspricht.

**6.** Sigma-Delta-Modulator (1) mit:

a) einem Multibit-Quantisierer (2) nach einem der Ansprüche 1 - 5,
b) einem Signaleingang (IN), an dem ein analoges Auswertesignal (x) anliegt und einem digitalen Ergebnisausgang (OUT), der dem digitalen Ergebniswert ($y_Q$) ausgibt,
c) mindestens einer dem Multibit-Quantisierer (2) vorgeschalteten Vorstufe (V), welche einen ein jeweiliges Vorstufen-Eingangssignal ($E_i$) verarbeiteten digitalen Addierer ($3_i$) und einen dem digitalen Addierer ($3_i$) im Signalweg nachgeschalteten Integrierer ($4_i$) aufweist, welcher ein Vorstufen-Ausgangssignal ($A_i$) liefert, wobei dem digitalen Addierer ($3_i$) ein in Abhängigkeit von dem Ergebniswert ($y_Q$) generiertes Rückkopplungssignal ($R_i$) zur Addition zu dem Vorstufen-Eingangssignal ($E_i$) zugeführt ist, wobei
d) an einer ersten Vorstufe ($V_1$) als Vorstufen-Eingangssignal ($E_1$) das Auswertesignal (x) anliegt und an jeder weiteren Vorstufe ($V_i$) als Vorstufen-Eingangssignal ($E_i$) das Vorstufen-Ausgangssignal ($A_{i-1}$) der jeweils im Signalweg vorherigen Vorstufe ($V_{i-1}$) anliegt, und wobei die letzte Vorstufe ($V_2$) vor dem Multibit-Quantisierer (2) dem Multibit-Quantisierer das Vorstufen-Ausgangssignal ($A_2$) als analoges Eingangssignal ($E_Q$) liefert.

**7.** Sigma-Delta-Modulator (1) nach Anspruch 6,
**dadurch gekennzeichnet,**
**dass** ein Digital-Analog-Wandler (6) vorgesehen ist, der aus dem digitalen Ergebniswert ($y_Q$) ein analoges Roh-Signal (RS) generiert.

**8.** Sigma-Delta-Modulator (1) nach Anspruch 7,
**dadurch gekennzeichnet,**
**dass** das Roh-Signal (RS) entsprechend der Position (i) und der Anzahl der Vorstufen ($V_i$) in dem Signalweg jeweils mit einem vorbestimmten Faktor ($b_i$) zum Erzeugen des jeweiligen Rückkopplungssignals ($R_i$) einer Vorstufe ($V_i$) multipliziert wird.

**9.** Sigma-Delta-Modulator (1) nach Anspruch 8,
**dadurch gekennzeichnet,**
**dass** der jeweilige Faktor ($b_i$) eine einfach gebrochene Zahl ist.

**10.** Sigma-Delta-Modulator (1) nach einem der Ansprüche 6 - 9,

**dadurch gekennzeichnet,**
**dass** der Sigma-Delta-Modulator (1) von zweiter Ordnung mit zwei Vorstufen ist.

**11.** Sigma-Delta-Modulator (1) nach einem der Ansprüche 6 - 10,
**dadurch gekennzeichnet,**
**dass** der Sigma-Delta-Modulator (1) ein zeitkontinuierlicher Sigma-Delta-Modulator (continuous time sigma delta modulator) ist.

**Claims**

**1.** Multi-bit quantizer (2) for a sigma-delta modulator (1), wherein:

a) the sigma-delta modulator (1) has at least one input stage ($V_1$, $V_2$) with an integrator ($4_1$, $4_2$) and the input stage supplies an analogue input signal ($E_Q$) to the multi-bit quantizer (2),
b) the multi-bit quantizer (2) quantizes the analogue input signal ($E_Q$) and outputs it as a digital result value ($y_Q$) at a digital result output (OUT),
c) the multi-bit quantizer (2) has a number of comparators (61) which are in each case supplied with the analogue input signal ($E_Q$);
**characterized in that**
d) each comparator (61) is supplied with a variable threshold signal ($y_{th,i}$) with a respective threshold signal voltage ($63_j$) and the comparator (61) outputs a respective result bit (Qi), the result bits (Qi) forming the digital result value ($y_Q$);
e) a digital adder (66) is provided which decreases or increases the threshold signal voltages ($63_i$) by a correction voltage ($y_{dac3}$) in dependence on the digital result value ($y_Q$), the correction voltage ($y_{dac3}$) being equal for all threshold signal voltages ($63_i$).

**2.** Multi-bit quantizer (2) according to Claim 1, **characterized in that** the number of comparators (61) corresponds to the resolution of the quantizer (2) and the threshold signal voltages ($V_{th,i}$) are equidistant.

**3.** Multi-bit quantizer (2) according to Claim 2, **characterized in that** a reference voltage generator (65) is provided which generates the threshold signal voltages ($63_i$) which are different for each comparator (61), the threshold signal voltages ($63_i$) being selectable in part-voltages (25).

**4.** Multi-bit quantizer (2) according to Claim 3, **characterized in that** a switching mechanism (65, 67) is allocated to the digital adder (66), which has controllable switching mechanism switches (67) which switch the part-voltages (25) of the reference voltage generator (65) to inputs of the comparators (61) for the threshold signal voltages ($63_i$), the switches being controlled by output signals (Add<0:6>) of the digital adder (66).

5. Multi-bit quantizer (2) according to one of Claims 1-4, **characterized in that** the correction voltage ($y_{dac3}$) corresponds to the result value ($y_Q$) multiplied by a fixed factor ($b_3$).

6. Sigma-delta modulator (1) comprising:

   a) a multi-bit quantizer (2) according to one of Claims 1 - 5,
   b) a signal input (IN) at which an analogue evaluation signal (x) is present, and a digital result output (OUT) which outputs the digital result value ($y_Q$),
   c) at least one input stage (V) preceding the multi-bit quantizer (2), which has a digital adder ($3_i$), processing a respective input-stage input signal ($E_i$), and an integrator ($4_i$) following the adder ($3_i$) on the signal path, which supplies an input-stage output signal ($A_i$), the digital adder ($3_i$) being supplied with a feedback signal ($R_i$), generated in dependence on the result value ($y_Q$), for addition to the input-stage input signal ($E_i$), wherein
   d) the evaluation signal (x) is present as input-stage input signal ($E_i$) at a first input stage ($V_i$), and the input-stage output signal ($A_{i-1}$) of the input stage ($V_{i-1}$) preceding in each case on the signal path is present at each further input stage ($V_i$) as input-stage input signal ($E_i$), and wherein the last input stage ($V_2$) before the multi-bit quantizer (2) supplies the input-stage output signal ($A_2$) to the multi-bit quantizer as analogue input signal ($E_Q$).

7. Sigma-delta modulator (1) according to Claim 6, **characterized in that** a digital-analogue converter (6) is provided which generates a raw analogue signal (RS) from the digital result value ($y_Q$).

8. Sigma-delta modulator (1) according to Claim 7, **characterized in that** the raw signal (RS) is in each case multiplied by a predetermined factor ($b_i$), according to the position (i) and the number of input stages ($V_i$) on the signal path, for generating the respective feedback signal ($R_i$) of an input stage ($V_i$).

9. Sigma-delta modulator (1) according to Claim 8, **characterized in that** the respective factor ($b_i$) is a fractional number.

10. Sigma-delta modulator (1) according to one of Claims 6 - 9, **characterized in that** the sigma-delta modulator (1) is of second order with two input stages.

11. Sigma-delta modulator (1) according to one of Claims 6 - 10, **characterized in that** the sigma-delta modulator (1) is a continuous-time sigma-delta modulator.

## Revendications

1. Quantificateur multibit (2) pour un modulateur sigma-delta (1), dans lequel :

   a) le modulateur sigma-delta (1) comprend au moins un étage préliminaire ($V_1$, $V_2$) avec un intégrateur ($4_1$, $4_2$) et l'étage préliminaire fournit un signal d'entrée analogique ($E_Q$) au quantificateur multibit (2),
   b) le quantificateur multibit (2) quantifie le signal d'entrée ($E_Q$) analogique et le délivre comme une valeur résultat numérique ($y_Q$) à une sortie de résultat numérique (OUT),
   c) le quantificateur multibit (2) comprend plusieurs comparateurs (61) auxquels est envoyé à chaque fois le signal d'entrée ($E_Q$) analogique ;
   **caractérisé en ce que**
   d) un signal de valeur seuil ($y_{th,i}$) variable est envoyé à chaque comparateur (61) avec une tension de signal de valeur seuil ($63_i$) correspondante et le comparateur (61) délivre un bit résultat ($Q_i$) correspondant, le bit résultat ($Q_i$) formant la valeur résultat numérique ($y_Q$);
   e) un additionneur numérique (66) est prévu, il diminue ou augmente d'une tension de correction ($y_{dac3}$) les tensions de signal de valeur seuil ($63_i$) en fonction de la valeur résultat numérique ($y_Q$), la tension de correction ($y_{dac3}$) étant identique pour toutes les tensions de signal de valeur seuil ($63_i$).

2. Quantificateur multibit (2) selon la revendication 1, **caractérisé en ce que** le nombre des comparateurs (61) correspond à la résolution du quantificateur (2) et les tensions de signal de valeur seuil ($V_{th,i}$) sont équidistantes.

3. Quantificateur multibit (2) selon la revendication 2, **caractérisé en ce que** un générateur de tension de référence (65) est prévu, il génère pour chaque comparateur (61) des tensions de signal de valeur seuil ($63_i$) différentes, les tensions de signal de valeur seuil ($63_i$) pouvant être choisies parmi des tensions partielles (25).

4. Quantificateur multibit (2) selon la revendication 3, **caractérisé en ce qu'** un dispositif de commutation (65, 67) est associé à l'additionneur (66) numérique, le dispositif de commutation comprend des commutateurs (67) pouvant être commandés qui appliquent les tensions partielles (25) du générateur de tension de référence (65) à des entrées des comparateurs (61) pour les tensions de signal de valeur seuil ($63_i$), les commutateurs pouvant être commandés par des signaux de sortie (Add<0:6>) de l'additionneur numérique (66).

5. Quantificateur multibit (2) selon une des revendications 1-4,
   **caractérisé en ce que**
   la tension de correction ($y_{dac3}$) correspond à la valeur résultat ($y_Q$) multipliée avec un facteur fixe ($b_3$).

6. Modulateur sigma-delta (1) comprenant :

   a) un quantificateur multibit (2) selon une des revendications 1-5,
   b) une entrée de signal (IN) à laquelle un signal d'exploitation analogique (x) est appliqué et une sortie de résultat numérique (OUT) qui délivre la valeur résultat numérique ($Y_Q$),
   c) au moins un étage préliminaire (V), connecté en amont d'un quantificateur multibit (2), qui comprend un additionneur numérique ($3_i$) traitant un signal d'entrée ($E_i$) d'étages préliminaires correspondant et un intégrateur ($4_i$) connecté en aval de l'additionneur ($3_i$) dans le trajet de signal, celui-ci fournit un signal de sortie d'étages préliminaires ($A_i$), un signal de rétroaction ($R_i$) généré en fonction d'une valeur résultat ($y_Q$) étant envoyé à l'additionneur ($3_i$) numérique pour l'addition avec le signal d'entrée d'étages préliminaires ($E_i$), dans lequel
   d) le signal d'évaluation (x) est appliqué au premier étage préliminaire ($V_1$) comme signal d'entrée d'étages préliminaires ($E_1$) et à chaque autres étages préliminaires ($V_i$), le signal de sortie d'étages préliminaires ($A_{i-1}$) de l'étage préliminaire ($V_{i-1}$) placé à chaque fois avant dans le trajet de signal est appliqué comme signal d'entrée d'étages préliminaires ($E_i$) et dans lequel le dernier étage préliminaire ($V_2$) avant le quantificateur multibit (2) fournit au quantificateur multibit le signal de sortie d'étages préliminaires ($A_2$) comme signal d'entrée analogique ($E_Q$).

7. Modulateur sigma-delta (1) selon la revendication 6,
   **caractérisé en ce qu'**
   un convertisseur numérique analogique (6) est prévu, il génère un signal brut analogique (RS) à partir de la valeur résultat ($y_q$) numérique.

8. Modulateur sigma-delta (1) selon la revendication 7,
   **caractérisé en ce que**
   le signal brut (RS) est multiplié à chaque fois avec un facteur ($b_i$) prédéterminé selon la position (i) et le nombre d'étages préliminaires ($V_i$) dans le trajet de signal pour produire le signal de rétroaction correspondant ($R_i$) d'un étage préliminaire ($V_i$).

9. Modulateur sigma-delta (1) selon la revendication 8,
   **caractérisé en ce que**
   le facteur correspondant ($b_i$) est un chiffre fractionné simple.

10. Modulateur sigma-delta (1) selon les revendications 6 - 9,
    **caractérisé en ce que**
    le modulateur sigma-delta (1) est de deuxième ordre avec deux étages préliminaires.

11. Modulateur sigma-delta (1) selon les revendications 6 -10,
    **caractérisé en ce que**
    le modulateur sigma-delta (1) est un modulateur sigma-delta constant dans le temps (continuous time sigma delta modulator).

EP 1 394 950 B1

Fig. 1

Fig. 2

9

Fig. 3

_10_

$y_2(t)$

$y_2(t)-y_{dac3}(t)$

$E_Q$

_2_

$y_2(t) - y_{dac3}(t) > y_{th,i}$ ?

$y_Q(t)$

OUT

$y_{dac3}(t) = b_3 * y_Q(t)$

$y_{th}$

**Fig. 4**

_2_

$y_2(t) > y_{th,i} + y_{dac3}(t)$ ?

$y_2(t)$

$y_Q(t)$

$y'_{th,i} = y_{th,i} + b_3 * y_Q(t)$

$y_Q(t)$

**Fig. 5**

**Fig. 6**

**Fig. 7**